# EUROPÄISCHE PATENTSCHRIFT

(11) **EP 2 814 309 B1**
(45) Veröffentlichungstag und Bekanntmachung des Hinweises auf die Patenterteilung: **26.12.2018**
(21) Anmeldenummer: 14169475.2
(22) Anmeldetag: 22.05.2014
(51) Int. Cl.: H05K 7/14

(54) **Halterahmen für eine Leiterplatte**
Mounting frame for a printed circuit board
Cadre de support pour une carte de circuits imprimés

(30) Priorität: 14.06.2013 DE 102013211136
(43) Veröffentlichungstag der Anmeldung: 17.12.2014
(73) Patentinhaber: ROBERT BOSCH GMBH, 70442 Stuttgart (DE)
(72) Erfinder: Rempler, Hans-Uwe, 70771 Leinfelden-Echterdingen (DE); Amalraj, Gurusamy Vijay, 560076 Bangalore (IN); Koehn, Dietrich, 71634 Ludwigsburg (DE); Buettner, Mathias, 71720 Oberstenfeld (DE); Hennel, Udo, 74343 Sachsenheim (DE)

(56) Entgegenhaltungen:
- EP-A2- 2 426 464
- US-A- 6 005 775
- US-A1- 2011 222 251
- US-B1- 7 040 905

## Beschreibung

### Stand der Technik

Die Schrift US 7,040,905 B1 beschreibt einen Gestellrahmen mit Halteelementen, Schnappverbindungen und Auflageelementen zur formschlüssigen Aufnahme einer Leiterplatte.

Die Schrift EP 2 426 464 A2 beschreibt einen Displaygehäusedeckel, welcher mit einer Leiterplatte gegenüber einem Gehäuse in 90°-Schritten drehbar realisiert ist. Im Inneren des Displaygehäusedeckels ist eine Leiterplatte auf einer Ausformung mit einer ersten Schnappverbindung formschlüssig fixiert. Nach außen reichende zweite Schnappverbindungselemente und Laschen greifen in Aufnahmestellen am Gehäuse ein und fixieren den Displaygehäusedeckel mit der Leiterplatte am Gehäuse. Der Displaygehäusedeckel und das Gehäuse weisen dabei an den zweiten Schnappverbindungselemente bzw. an den Aufnahmestellen Öffnungen des Gehäuses gegenüber der Umwelt auf.

Der vorliegenden Erfindung liegt die Aufgabe zugrunde, einen in einem Gehäuse einrastbaren Halterahmen zur Verfügung zu stellen, wobei in dem Halterahmen verschiedene Leiterplattengeometrien aufgenommen werden können und, wobei der Halterahmen gegenüber dem Gehäuse federnd gelagert ist.

### Offenbarung der Erfindung

Die Erfindung betrifft einen Halterahmen für eine Leiterplatte. Der Halterahmen weist eine Trägerstruktur und wenigstens zwei Auflageschultern auf. Die Auflageschultern sind jeweils mit der Trägerstruktur verbunden und ausgebildet und angeordnet, gegen einen Flächenbereich der Leiterplatte - insbesondere im Bereich eines Leiterplattenrandes der Leiterplatte - zu stützen. Der Halterahmen weist einen Rasthaken, insbesondere einen Bajonett-Haken auf, wobei der Rasthaken ausgebildet und angeordnet ist, einen Leiterplattenrand der Leiterplatte zu umgreifen und die Leiterplatte formschlüssig zwischen der wenigstens einen Auflageschulter und dem Rasthaken zu halten.

Durch den so ausgebildeten Halterahmen kann vorteilhaft dasselbe Gehäusemuster für zueinander verschiedene Leiterplatten verwendet werden, da der so ausgebildete Halterahmen individuell für zueinander verschiedene Leiterplatten gefertigt werden kann. Der Halterahmen ist beispielsweise aus Kunststoff, insbesondere mittels Spritzguss, gebildet.

Bevorzugt sind die Auflageschultern und/oder die Rasthaken an die Trägerstruktur angeformt.

In einer bevorzugten Ausführungsform weist die Trägerstruktur zwei sich jeweils längs erstreckende Schienen auf, wobei die Auflageschultern und die Rasthaken an wenigstens einer der Schienen angeformt sind. Weiter bevorzugt verlaufen die Schienen parallel zueinander. Die Schienen sind bevorzugt mittels wenigstens einer Strebe miteinander verbunden.

Bevorzugt bilden zwei Schienen und zwei Streben einen rechteckigen Rahmen, sodass die Leiterplatte in dem rechteckigen Rahmen aufgenommen werden kann.

Mittels der Schienen kann vorteilhaft eine aufwandsgünstige Halterung für die Leiterplatte gebildet sein.

In einer bevorzugten Ausführungsform weist der Halterahmen wenigstens ein - insbesondere an den Halterahmen angeformtes - Stützelement auf. Bevorzugt erstreckt sich das Stützelement von dem Halterahmen abweisend und ist ausgebildet, in eine Öffnung eines Gehäuses einzugreifen und den Halterahmen mit dem Gehäuse formschlüssig und/oder kraftschlüssig zu verbinden. Mittels des Stützelementes kann der Halterahmen vorteilhaft mit dem Gehäuse verbunden, bevorzugt in der Öffnung verankert werden. Der Halterahmen kann so vorteilhaft schnell und einfach mit dem Gehäuse verbunden, bevorzugt zusammengesteckt werden.

In einer bevorzugten Ausführungsform ist das Stützelement als federndes Rastelement ausgebildet, wobei das Stützelement ausgebildet ist, in die Öffnung federnd einzurasten, sodass der Halterahmen mit dem Gehäuse rastend steckverbunden werden kann. So kann vorteilhaft eine aufwandsgünstige Verbindungsweise zwischen dem Halterahmen und dem Gehäuse gebildet sein.

Das Gehäuse kann beispielsweise vier zueinander jeweils beabstandete Öffnungen aufweisen, wobei die Abstände zwischen den Öffnungen vorbestimmt sind und so bei einer Serie von Gehäusen jeweils gleich sind. Weiter vorteilhaft können so zueinander verschieden große Leiterplatten über die jeweils an die Leiterplatten angepasste Halterahmen mit dem Gehäuse verbunden werden. Dazu entsprechen die Abstände zwischen den Stützelementen eines jeden Halterahmens für jeweils zueinander verschiedene Leiterplatten den Abständen der Öffnungen in dem Gehäuse.

In einer bevorzugten Ausführungsform ist das Stützelement als Stützbein ausgebildet. Das Stützbein ist ausgebildet, in eine Öffnung eines Gehäuses kraftschlüssig einzugreifen, sodass der Halterahmen mit dem Gehäuse kraftschlüssig steckverbunden werden kann. Die Öffnung in dem Gehäuse ist beispielsweise durch eine zylindrische Bohrung gebildet. Die zylindrische Bohrung kann beispielsweise in einem Befestigungsdom ausgebildet sein, welcher an das Gehäuse, beispielsweise ein Kunststoffgehäuse, angeformt ist. Bevorzugt ist das Stützbein wenigstens auf einem Endabschnitt zylinderförmig ausgebildet. So kann das Stützbein vorteilhaft in eine zylinderförmige Bohrung, welche die zuvor genannte Öffnung bildet, zum Steckverbinden mit dem Gehäuse eingeführt werden.

In einer bevorzugten Ausführungsform weist das Stützbein einen zylinderförmigen Endabschnitt auf, welcher ausgebildet ist, in eine hohlzylinderförmige Öffnung des Gehäuses einzugreifen.

In einer bevorzugten Ausführungsform weist das Stützelement einen sich in Richtung der flachen Erstreckung der Auflageschulter erstreckenden Rasthaken auf, welcher ausgebildet ist, in eine Öffnung einer Gehäusewand des Gehäuses einzugreifen. Bevorzugt ist der Rasthaken über wenigstens eine, bevorzugt zwei mäanderförmige, insbesondere U-förmige Federn mit der Schiene verbunden. Die wenigstens eine Feder ist bevorzugt ausgebildet, den Rasthaken quer zur flachen Erstreckung der Auflageschulter federnd zu ziehen. So kann vorteilhaft die Leiterplatte mittels der Federn und des Rasthakens an die Auflageschultern fest angepresst werden. Weiter vorteilhaft können mittels der mäanderförmigen Federn hohe Anpresskräfte erzielt werden.

Bevorzugt ist der Halterahmen aus faserverstärktem Kunststoff gebildet. Der Kunststoff ist beispielsweise Polyamid, Polybutylenterephthalat, Flüssigkristallpolymer, Acrylnitril-Butadien-Styrol, oder Polyacryl.

In einer bevorzugten Ausführungsform ist der Halterahmen mittels Spritzguss hergestellt. Weiter bevorzugt sind die Fasern des faserverstärkten Kunststoffs Glasfasern oder Kohlefasern. Die Glasfasern weisen bevorzugt jeweils eine derartige Länge auf, dass sie im Spritzguss durch Spritzgussöffnungen hindurchfließen und sich mit ihrer Längserstreckung in der Längserstreckung der Schienen parallel zur Längserstreckung der Schienen ausrichten.

Die Erfindung betrifft auch ein Gehäuse mit einem Halterahmen der vorbeschriebenen Art. Das Gehäuse weist eine Gehäuseschale und einen Gehäusedeckel auf. Der Gehäusedeckel ist bevorzugt ausgebildet, die Gehäuseschale zu verschließen. Bevorzugt weist die Gehäusewand des Gehäuses wenigstens eine Öffnung für das Stützelement auf, sodass der Halterahmen durch Einführen des Stützelements in die Öffnung in einem von dem Gehäuse umschlossenen Hohlraum angeordnet und mit der Gehäusewand insbesondere trennbar verbunden ist.

Die Erfindung betrifft auch ein Verbindungssystem. Das Verbindungssystem weist wenigstens ein Gehäuse, insbesondere Gehäusemodell der vorbeschriebenen Art und wenigstens zwei zueinander verschiedene Halterahmen der vorbeschriebenen Art auf. Die zueinander verschiedenen Halterahmen weisen jeweils zueinander verschiedene Größen auf, insbesondere zueinander verschiedene Längserstreckungen der Schienen.

Bevorzugt weisen die Stützelemente, welche an den Halterahmen angeformt sind, jeweils für Halterahmen mit zueinander verschiedenen Längserstreckungen der Schienen jeweils denselben Abstand zueinander auf. Durch das Verbindungssystem können vorteilhaft zueinander verschieden große Leiterplatten über jeweils an die Leiterplatte angepasste Halterahmen mit demselben Gehäuse, insbesondere Gehäusetyp verbunden werden, so dass eine Spritzgussform für das Gehäuse nicht geändert werden muss. Vielmehr werden die Leiterplatten über den jeweiligen Halterahmen an das Gehäuse adaptiert.

Die Erfindung betrifft auch ein Verfahren zum Befestigen einer Leiterplatte in einem Gehäuse.

Bei dem Verfahren wird eine Leiterplatte in einen Halterahmen eingerastet und von dem Halterahmen gehalten.

Weiter wird der Halterahmen mit einem an den Halterahmen angeformten Stützelement mit dem Gehäuse steckverbunden, so dass die Leiterplatte in einem von dem Gehäuse umschlossenen Hohlraum in einer vorbestimmten Position gehalten ist.

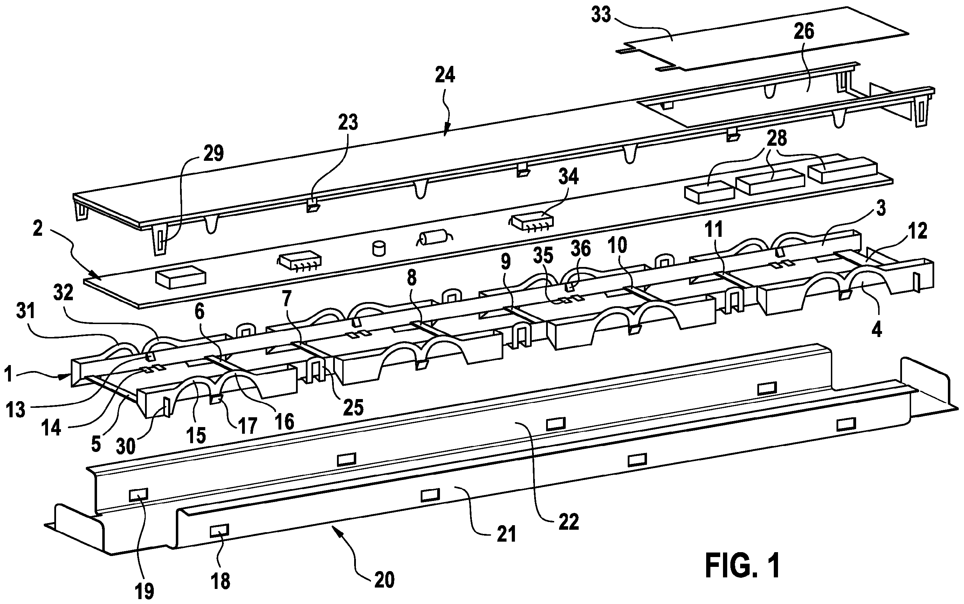

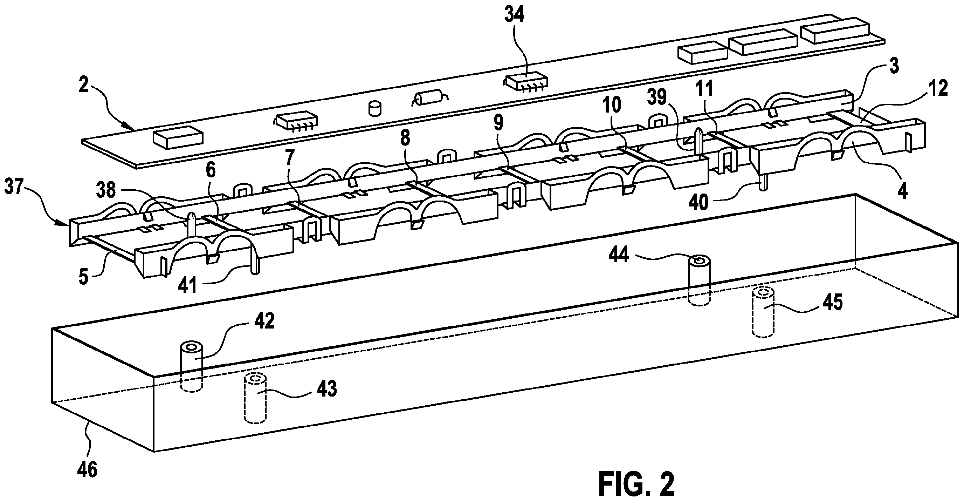

Die Erfindung wird nun im Folgenden anhand von Figur 2 beschrieben. Bei dem Ausführungsbeispiel aus Figur 1 handelt es sich um ein Beispiel, welches das Verständnis der Erfindung erleichtert. Weitere vorteilhafte Ausführungsvarianten ergeben sich aus den Merkmalen der Figuren und der abhängigen Ansprüche.
Figur 1 zeigt ein Ausführungsbeispiel für einen Halterahmen, welcher mit einem Gehäuseteil steckverbunden werden kann, und einen Gehäusedeckel, welcher mit dem Halterahmen Steckverbunden werden kann. Der Halterahmen ist ausgebildet, eine Leiterplatte aufzunehmen und festzuhalten.
Figur 2 zeigt ein Ausführungsbeispiel für einen Halterahmen mit angeformten Stützbeinen, die in Aussparungen einer Gehäuseschale eingesteckt werden können, so dass der Halterahmen mit der Gehäuseschale steckverbunden werden kann.

Figur 1 zeigt ein Ausführungsbeispiel für einen Halterahmen 1, welcher ausgebildet ist, eine Leiterplatte 2 aufzunehmen und festzuhalten und welcher ausgebildet ist, in einem Gehäuse, insbesondere eine Gehäuseschale 20, steckbar verbunden zu werden.

Der Halterahmen 1 weist dazu eine sich längs erstreckende Schiene 3 und eine sich längs erstreckende Schiene 4 auf, welche in diesem Ausführungsbeispiel jeweils die gleiche Länge aufweisen und welche parallel zueinander beabstandet sind. Die Schienen 3 und 4 sind in diesem Ausführungsbeispiel mittels acht Verbindungsstegen, nämlich einem Verbindungssteg 5, einem Verbindungssteg 6, einem Verbindungssteg 7, einem Verbindungssteg 8, einem Verbindungssteg 9, einem Verbindungssteg 10 und einem Verbindungssteg 11, und mit einem Verbindungssteg 12 miteinander verbunden. Die Verbindungsstege 5, 6, 7, 8, 9, 10, 11 und 12 sind in diesem Ausführungsbeispiel zusammen mit den Schienen 3 und 4 mittels Spritzgießen erzeugt und sind beispielsweise aus Kunststoff gebildet. Die Schienen 3 und 4 und die zuvor erwähnten Stege bilden gemeinsam die zuvor erwähnte Trägerstruktur.

An die Schienen 3 und 4 sind jeweils zueinander gegenüberliegende Auflageschultern angeformt. Weiter ist an jede Schiene im Bereich einer Auflageschulter ein Rasthaken angeformt, welcher ausgebildet ist, die Leiterplatte 2 gegen die Auflageschulter im Bereich des Rasthakens zu pressen. Dazu ist der Rasthaken beispielsweise als Bajonett-Haken ausgebildet, sodass die Leiterplatte 2 zum Einführen in einen sich zwischen dem Rasthaken und der Auflageschulter erstreckenden Aufnahmebereich entlang einer Schräge des Bajonett-Hakens geführt werden kann und dabei den Rasthaken zusammen mit der Schiene federnd nach außen pressen kann.

Der Rasthaken 13 an der Schiene 3 ist beispielhaft bezeichnet. Im Bereich des Rasthakens 13 ist eine Auflageschulter 14 angeformt, wobei die Auflageschulter zwei zueinander beabstandete von der Schiene nach innen weisende Vorsprünge umfasst. Die Vorsprünge der Auflageschulter 14 sind in Längsrichtung der Schiene zueinander beabstandet angeordnet und schließen in einer Projektion den Rasthaken 13 zwischeneinander ein.

Die Schienen 3 und 4 weisen in diesem Ausführungsbeispiel jeweils vier Rasthaken wie den Rasthaken 13 auf, und vier Auflageschultern wie die Auflageschulter 14 und die von dem Auflageschulterpaar entlang einer Längserstreckung der Schiene 3 beabstandet angeordnete, und mit der Schiene 3 verbundene Auflageschulter 35. Im Bereich der Auflageschulter 35 weit die Schiene 3 einen Rasthaken 36 auf.

Die Rasthaken 13 und 36 sind jeweils ausgebildet, mit dem Leiterplattenrand der Leiterplatte 2 zu verrasten und diesen formschlüssig gegen die Auflageschulter 14 beziehungsweise 35 zu pressen.

Der Halterahmen 1 weist in diesem Ausführungsbeispiel auch Stützelemente zum Verbinden des Halterahmens mit der Gehäuseschale 20 auf. Dazu sind an den Halterahmen acht federnd ausgebildete Rasthaken angeformt, welche sich jeweils von den Schienen nach außen erstrecken und welche jeweils ausgebildet sind, in eine Öffnung der Gehäuseschale 20 rastend einzugreifen. Der Rasthaken 17 ist beispielhaft bezeichnet. An den Rasthaken 17 sind zwei U-förmige Mäander angeformt, wobei der Rasthaken 17 zwei zueinander benachbart angeordnete U-Schenkel der zueinander verschiedenen Mäander miteinander verbindet. Die von dem Rasthaken 17 jeweils abweisenden U-Schenkel der zueinander verschiedenen Mäander sind an den Halterahmen 1, in diesem Ausführungsbeispiel an die Schiene, angeformt. Der Rasthaken 17 ist in diesem Ausführungsbeispiel mit einem Mäander 16 und einem Mäander 15 verbunden und ist so über die Mäander 15 und 16 mit der Schiene 4 verbunden.

Die Gehäuseschale 20 weist für jeden Rasthaken wie den Rasthaken 17 eine Öffnung auf, wobei die Öffnung 18 für den Rasthaken 17 beispielhaft bezeichnet ist. Die Schiene 3 weist - zum Rasthaken 17, welcher an die Schiene 4 angeformt ist, gegenüberliegend - zwei an die Schiene 3 angeformte Mäander 31 und 32 auf, welche jeweils mit einem in der in Figur 1 dargestellten Aufsicht verborgenen Rasthaken verbunden sind. Der verborgene Rasthaken kann in eine Öffnung 19 der Gehäuseschale 20 eingreifen.

Die Mäander 15, 16, 31 und 32 bilden jeweils eine Feder. Die Mäander 15 und 16 sind ausgebildet, den Rasthaken 17 quer zu einer Flachenerstreckung des Halterahmens 1 zu ziehen.

Die Gehäuseschale 20 ist in diesem Ausführungsbeispiel als Blechschale ausgebildet. Die Gehäuseschale 20 weist ein U-förmiges Querschnittsprofil auf. Die Gehäuseschale 20 weist so einen U-Schenkel 21 und einen U-Schenkel 22 auf.

Die U-Schenkel 21 und 22 erstrecken sich jeweils parallel zueinander und bilden so jeweils eine Gehäusewand der Gehäuseschale 20. Die Gehäuseschale 20 ist ausgebildet, den Halterahmen 1 zusammen mit der Leiterplatte 2 in einem zwischen den U-Schenkeln 21 und 22 eingeschlossenen Hohlraum aufzunehmen.

Der Halterahmen 1 kann dazu zusammen mit der mit dem Halterahmen 1 verrasteten Leiterplatte 2 in die Gehäuseschale 20 eingefügt werden. Dabei kann der Halterahmen 1, insbesondere die Schienen 3 und 4, mit einem sich zwischen den U-Schenkeln 21 und 22 erstreckenden Boden der Gehäuseschale 20 aufliegen. Die Rasthaken, wie der Rasthaken 17, der mit den Mäandern 15 und 16 verbunden ist, federn dabei - gedrückt durch die U-Schenkel 21 und 22 - nach innen. Die Rasthaken wie der Rasthaken 17 sind dann noch von den Öffnungen wie der Öffnung 18 zum Gehäuseboden der Gehäuseschale 20 beabstandet. Die Mäander 15 und 16 weisen in diesem Ausführungsbeispiel konvex von der Gehäuseschale 20 ab. Die Rasthaken wie der Rasthaken 17 können so durch Druck auf die Mäander 15 und 16 in Richtung der Gehäuseschale 20 bewegt werden und so in die Öffnungen wie die Öffnung 18 einrasten. Der Rasthaken 17 ist beispielsweise als Bajonett-Haken oder als quader- oder zylinderförmiger Vorsprungsbereich ausgebildet. Die Öffnungen wie die Öffnung 18 sind in diesem Ausführungsbeispiel als Durchbruch in einem der U-Schenkel ausgebildet.

Die Gehäuseschale 20 bildet in diesem Ausführungsbeispiel zusammen mit einem Gehäusedeckel 24 ein verschließbar ausgebildetes Gehäuse. Der Gehäusedeckel 24 ist dazu ausgebildet, mit dem Halterahmen 1 rastend verbunden zu werden und so das Gehäuse, insbesondere die Gehäuseschale 20 zu verschließen.

Dazu sind an den Gehäusedeckel 24 von dem Gehäusedeckel 24 sich abweichend erstreckende Schlaufen wie die Schlaufe 29 angeformt. Die Schlaufe 29 ist ausgebildet, mit einem an den Halterahmen 1 angeformten Vorsprungsbereich 30 formschlüssig zu verrasten.

Zusätzlich zu den an den Gehäusedeckel 24 angeformten Schlaufen wie die Schlaufe 29 sind an den Halterahmen 1 Schlaufen wie die Schlaufe 25 angeformt, welche ausgebildet und angeordnet ist, beim Zusammenstecken des Gehäusedeckels 24 mit dem Halterahmen 1 mit dem Vorsprungsbereich 23 formschlüssig zu verrasten.

Der Gehäusedeckel 24 ist beispielsweise aus Kunststoff, insbesondere spritzgegossenen Kunststoff gebildet. Der Kunststoff ist beispielsweise Polyamid, Polybutylenterephthalat, Flüssigkristallpolymer, Acrylnitril-Butadien-Styrol, oder Polyacryl.

Der Gehäusedeckel 24 weist in diesem Ausführungsbeispiel eine Gehäuseöffnung 26 auf, welche mittels eines weiteren Gehäusedeckels 33 verschlossen werden kann. Die Gehäuseöffnung 26 ist im Bereich von elektrischen Kontakten 28 der Leiterplatte 2 angeordnet. Die elektrischen Kontakte 28 sind so auch nach Verschließen des Gehäusedeckels 24 durch die mittels des Gehäusedeckels 33 verschließbare Gehäuseöffnung 26 zugänglich. Auf der Leiterplatte 2 sind elektronische Bauelemente angeordnet, von denen ein Mikroprozessor 34 beispielhaft bezeichnet ist.

Figur 2 zeigt ein Ausführungsbeispiel für einen Halterahmen 37, welcher als Stützelement vier Stützbeine 38, 39, 40 und 41 aufweist. Der Halterahmen 37 weist wie der Halterahmen 1 zwei Schienen 3 und 4 auf, welche über Stege 5, 6, 7, 8, 9, 10, 11 und 12 miteinander verbunden sind. Die Stützbeine 38 und 39 sind an die Schiene 3 des Halterahmens 37 angeformt, die Stützbeine 40 und 41 sind an die Schiene 4 des Halterahmens 37 angeformt. Die Stützbeine 38, 39, 40 und 41 sind jeweils zylindrisch geformt und weisen jeweils quer zu einer flachen Erstreckung des Halterahmens 37 ab. Die Stützbeine 38, 39, 40 und 41 können entsprechende Öffnungen 42, 43, 44 und 45 eines Gehäuses 46 zusammen mit dem Halterahmen 37, oder zusätzlich einer in dem Halterahmen 37 gehaltenen Leiterplatte 2, eingesteckt werden. Die Öffnungen 42, 43, 44 und 45 sind beispielsweise jeweils hohlzylindrisch in einem an die Gehäuseschale angeformten Befestigungsdom ausgebildet.

## Patentansprüche

1. Halterahmen (37) für eine Leiterplatte (2), wobei der Halterahmen (37) eine Trägerstruktur (3, 4, 5) und wenigstens zwei Auflageschultern (14, 35) aufweist, wobei die Auflageschultern jeweils mit der Trägerstruktur (3, 4, 5) verbunden und ausgebildet und angeordnet sind, gegen einen Flächenbereich der Leiterplatte (2) zu stützen, wobei der Halterahmen (37) einen Rasthaken (13, 36), insbesondere Bajonetthaken aufweist, welcher ausgebildet und angeordnet ist, einen Leiterplattendrand der Leiterplatte (2) zu umgreifen und die Leiterplatte (2) formschlüssig zwischen der wenigstens einen Auflageschulter (14, 35) und dem Rasthaken (13, 36) zu halten,
**dadurch gekennzeichnet, dass**
der Halterahmen (37) wenigstens ein an den Halterahmen (37) angeformtes Stützelement (17) aufweist, wobei das Stützelement (17) sich von dem Halterahmen (37) abweisend erstreckt und ausgebildet ist, in eine Öffnung (18) eines Gehäuses einzugreifen und den Halterahmen (37) mit dem Gehäuse formschlüssig und/oder kraftschlüssig zu verbinden, und
am Halterahmen (37) wenigstens ein Stützbein (38, 39, 40, 41) angeformt ist, welches ausgebildet ist, in eine Öffnung (42, 43, 44, 45) eines Gehäuses (46) kraftschlüssig einzugreifen, so dass der Halterahmen mit dem Gehäuse (46) kraftschlüssig steckverbunden werden kann, und
der Halterahmen (37) dazu eingerichtet ist, mit der Leiterplatte (2) in einem vom Gehäuse umschlossenen Hohlraum angeordnet zu werden, wobei das Gehäuse (46) eine Gehäuseschale und einen Gehäusedeckel umfasst.

2. Halterahmen (37) nach Anspruch 1, **dadurch gekennzeichnet, dass** die Trägerstruktur (3, 4, 5) zwei zueinander parallel verlaufende sich jeweils längserstreckende Schienen (3, 4) aufweist, wobei die Auflageschultern (14, 35) und die Rasthaken (13, 36) an wenigstens einer der Schienen (3, 4) angeformt sind.

3. Halterahmen (37) nach Anspruch 1 oder Anspruch 2, **dadurch gekennzeichnet, dass** das Stützelement (17) als federndes Rastelement ausgebildet ist, welches ausgebildet ist, in die Öffnung (18) federnd einzurasten, so dass der Halterahmen (37) mit dem Gehäuse (21) rastend steckverbunden werden kann.

4. Halterahmen (37) nach Anspruch 3, **dadurch gekennzeichnet, dass** das Stützelement (17) einen sich in Richtung der flachen Erstreckung der Auflageschulter erstreckenden Rasthaken aufweist, welcher ausgebildet ist in eine Öffnung einer Gehäusewand des Gehäuses einzugreifen, und wobei der Rasthaken über wenigstens eine mäanderförmige, insbesondere U-förmige Feder (16, 17) mit der Schiene (3, 4) verbunden ist, und die wenigstens eine Feder (16, 17) ausgebildet ist, den Rasthaken quer zur flachen Erstreckung der Auflageschulter federnd zu ziehen.

5. Halterahmen (37) nach Anspruch 1, **dadurch gekennzeichnet, dass** das Stützbein (38, 39, 40, 41) einen zylinderförmigen Endabschnitt aufweist, welcher ausgebildet ist, in die hohlzylinderförmige Öffnung (42, 43, 44, 45) des Gehäuses (46) einzugreifen.

6. Halterahmen (37) nach einem der vorhergehenden Ansprüche, **dadurch gekennzeichnet, dass** der Halterahmen (37) aus faserverstärktem Kunststoff gebildet ist.

7. Gehäuse (46) mit einem Halterahmen (37) nach einem der Ansprüche 1 bis 6, wobei das Gehäuse (46) eine Gehäuseschale (46) und einen Gehäusedeckel aufweist, **dadurch gekennzeichnet, dass** eine Gehäusewand des Gehäuses (46) wenigstens eine Öffnung (42, 43, 44, 45) für das Stützbein (38, 39, 40, 41) aufweist, so dass der Halterahmen (1) durch Einführen des Stützbeins (38, 39, 40, 41)in die Öffnung (42, 43, 44, 45) in einem von dem Gehäuse (46) umschlossenen Hohlraum angeordnet und mit der Gehäusewand verbunden ist.

8. Verbindungssystem mit wenigstens einem Gehäuse (46) nach Anspruch 7 und wenigstens zwei zueinander verschiedene Halterahmen (37) gemäß einem der Ansprüche 1 bis 6, bei dem die zueinander verschiedenen Halterahmen (37) jeweils zueinander verschiedene Größen, insbesondere Längserstreckungen der Schienen (3, 4) aufweisen, wobei die Stützbeine (38, 39, 40, 41), welche an den Halterahmen (37) angeformt sind, jeweils für Halterahmen (37) mit zueinander verschiedenen Größen, insbesondere Längserstreckungen der Schienen (3, 4) jeweils denselben Abstand zueinander aufweisen.

9. Verfahren zum Befestigen einer Leiterplatte (2) in einem Gehäuse (46), bei dem eine Leiterplatte (2) in einen Halterahmen (37) nach einem der Ansprüche 1 bis 6 eingerastet wird und von dem Halterahmen (37) gehalten wird, und der Halterahmen (37) mit einem an den Halterahmen (37) angeformten Stützbein (38, 39, 40, 41)mit dem Gehäuse (46) steckverbunden wird, so dass die Leiterplatte (2) in einem von dem Gehäuse (46) umschlossenen Hohlraum in einer vorbestimmten Position gehalten ist.

## Claims

1. Holding frame (37) for a printed circuit board (2), wherein the holding frame (37) has a carrier structure (3, 4, 5) and at least two bearing shoulders (14, 35), wherein the bearing shoulders are each connected to the carrier structure (3, 4, 5) and are designed and arranged to be supported against a surface region of the printed circuit board (2), wherein the holding frame (37) has a latching hook (13, 36), in particular bayonet hook, which is designed and arranged to engage around a printed circuit board edge and to hold the printed circuit board (2) between the at least one bearing shoulder (14, 35) and the latching hook (13, 36) in an interlocking manner, **characterized in that**
the holding frame (36) has at least one supporting element (17) which is integrally formed on the holding frame (37), wherein the supporting element (17) extends in a manner pointing away from the holding frame (37) and is designed to engage into an opening (18) in the housing and to connect the holding frame (37) to the housing in an interlocking and/or force-fitting manner, and
at least one supporting limb (38, 39, 40, 41) is integrally formed on the holding frame (37) and is designed to engage into an opening (42, 43, 44, 45) in a housing (46) in a force-fitting manner, so that the holding frame can be plug-connected to the housing (46) in a force-fitting manner, and
the holding frame (37) is designed to be arranged with the printed circuit board (2) in a cavity which is enclosed by the housing, wherein the housing (46) comprises a housing shell and a housing cover.

2. Holding frame (37) according to Claim 1, **characterized in that** the carrier structure (3, 4, 5) has two longitudinally extending rails (3, 4) which run parallel to one another, wherein the bearing shoulders (14, 35) and the latching hooks (13, 36) are integrally formed on at least one of the rails (3, 4).

3. Holding frame (37) according to Claim 1 or Claim 2, **characterized in that** the supporting element (17) is designed as a resilient latching element which is designed to latch into the opening (18) in a resilient manner, so that the holding frame (37) can be plug-connected to the housing (21) in a latching manner.

4. Holding frame (37) according to Claim 3, **characterized in that** the supporting element (17) has a latching hook which extends in the direction of the flat extent of the bearing shoulder and is designed to engage into an opening in a housing wall of the housing, and wherein the latching hook is connected to the rail (3, 4) by means of at least one meandering, in particular U-shaped, spring (16, 17), and the at least one spring (16, 17) is designed to pull the latching hook transversely in relation to the flat extent of the bearing shoulder in a resilient manner.

5. Holding frame (37) according to Claim 1, **characterized in that** the supporting limb (38, 39, 40, 41) has a cylindrical end section which is designed to engage into the hollow-cylindrical opening (42, 43, 44, 45) in the housing (46).

6. Holding frame (37) according to one of the preceding claims, **characterized in that** the holding frame (37) is formed from a fibre-reinforced plastic.

7. Housing (46) comprising a holding frame (37) according to one of Claims 1 to 6, wherein the housing (46) has a housing shell (46) and a housing cover, **characterized in that** a housing wall of the housing (46) has at least one opening (42, 43, 44, 45) for the supporting limb (38, 39, 40, 41), so that the holding frame (1) is arranged in a cavity, which is enclosed by the housing (46), and is connected to the housing wall by way of insertion of the supporting limb (38, 39, 40, 41) into the opening (42, 43, 44, 45).

8. Connecting system comprising at least one housing (46) according to Claim 7 and at least two holding frames (37), which differ from one another, according to one of Claims 1 to 6, in which connecting system the holding frames (37) which differ from one another each have sizes, in particular longitudinal extents of the rails (3, 4), which differ from one another, wherein the supporting limbs (38, 39, 40, 41), which are integrally formed on the holding frame (37), are in each case at the same distance from one another for holding frames (37) with sizes, in particular longitudinal extents of the rails (3, 4), which differ from one another.

9. Method for securing a printed circuit board (2) in a housing (46), in which method a printed circuit board (2) is latched into a holding frame (37) according to one of Claims 1 to 6 and is held by the holding frame (37), and the holding frame (37) is plug-connected to the housing (46) by way of a supporting limb (38, 39, 40, 41) which is integrally formed on the holding frame (37), so that the printed circuit board (2) is held in a predetermined position in a cavity which is enclosed by the housing (46).

## Revendications

1. Cadre de support (37) pour une carte de circuit (2), le cadre de support (37) présentant une structure porteuse (3, 4, 5) et au moins deux épaulements de pose (14, 35), chacun des épaulements de pose étant relié à la structure porteuse (3, 4, 5) et étant configuré et disposé pour s'appuyer sur une partie de la surface de la carte de circuit (2), le cadre de support (37) présentant un crochet d'encliquetage (13, 36) et en particulier un crochet à baïonnette configuré et disposé pour chevaucher le bord de la carte de circuit (2) et maintenir la carte de circuit (2) en correspondance géométrique entre le ou les épaulements de pose (14, 35) et le crochet d'encliquetage (13, 36), **caractérisé en ce que**
le cadre de support (37) présente au moins un élément de soutien (17) formé sur le cadre de support (37), l'élément de soutien (17) s'étendant hors du cadre de support (37) et étant configuré pour s'engager dans une ouverture (18) d'un boîtier et relier en correspondance géométrique et/ou en correspondance mécanique le cadre de support (37) au boîtier,
**en ce qu'**au moins une jambe de soutien (38, 39, 40, 41) est formée sur le cadre de support (37) et est configurée pour s'engager en correspondance mécanique dans une ouverture (42, 43, 44, 45) d'un boîtier (46) de telle sorte que le cadre de support puisse être relié en correspondance mécanique au boîtier (46) par enfichage et
**en ce que** le cadre de support (37) est conçu pour être disposé avec la carte de circuit (2) dans une cavité entourée par le boîtier, le boîtier (46) comportant une coquille de boîtier et un couvercle de boîtier.

2. Cadre de support (37) selon la revendication 1, **caractérisé en ce que** la structure porteuse (3, 4, 5) présente deux rails (3, 4) s'étendant parallèlement l'un à l'autre et en longueur, les épaulements de pose (14, 35) et les crochets d'encliquetage (13, 36) étant formés sur au moins l'un des rails (3, 4).

3. Cadre de support (37) selon la revendication 1 ou la revendication 2, **caractérisé en ce que** l'élément de soutien (17) est configuré comme élément d'encliquetage élastique configuré pour s'encliqueter élastiquement dans l'ouverture (18) de telle sorte que le cadre de support (37) puisse être relié au boîtier (21) par enfichage encliqueté.

4. Cadre de support (37) selon la revendication 3, **caractérisé en ce que** l'élément de soutien (17) présente un crochet d'encliquetage qui s'étend dans la direction de l'extension plane de l'épaulement de pose et configuré pour s'engager dans une ouverture d'une paroi du boîtier, le crochet d'encliquetage étant relié au rails (3, 4) par l'intermédiaire d'au moins un ressort (16, 17) en forme de méandre et en particulier en forme de U, le ou les ressorts (16, 17) étant configurés pour tirer élastiquement le crochet d'encliquetage transversalement à l'extension plane de l'épaulement de pose.

5. Cadre de support (37) selon la revendication 1, **caractérisé en ce que** la jambe de soutien (38, 39, 40, 41) présente une section d'extrémité de forme cylindrique configurée pour s'engager dans l'ouverture (42, 43, 44, 45) en forme de cylindre creux du boîtier (46) .

6. Cadre de support (37) selon l'une des revendications précédentes, **caractérisé en ce que** le cadre de support (37) est réalisé en matière synthétique renforcée de fibres.

7. Boîtier (46) doté d'un cadre de support (37) selon l'une des revendications 1 à 6, le boîtier (46) présentant une coquille de boîtier (46) et un couvercle de boîtier,
**caractérisé en ce que**
une paroi du boîtier (46) présente au moins une ouverture (42, 43, 44, 45) pour la jambe de soutien (38, 39, 40, 41), de telle sorte que le cadre de support (1) soit disposé dans une cavité entourée par le boîtier (46) par insertion de la jambe de soutien (38, 39, 40, 41) dans l'ouverture (42, 43, 44, 45) et soit relié à la paroi du boîtier.

8. Système de liaison présentant au moins un boîtier (46) selon la revendication 7 et au moins deux cadres de support (37) différents l'un de l'autre selon l'une des revendications 1 à 6, dans lequel les cadres de support (37) différents l'un de l'autre présentent des tailles différentes l'une de l'autre, et en particulier différentes extensions longitudinales des rails (3, 4), les jambes de soutien (38, 39, 40, 41) formées sur le cadre de support (37) présentant chacune la même distance mutuelle pour les cadres de support (37) de tailles différentes et en particulier différentes extensions longitudinales des rails (3, 4).

9. Procédé de fixation d'une carte de circuit (2) dans un boîtier (46), dans lequel une carte de circuit (2) est encliquetée dans un cadre de support (37) selon l'une des revendications 1 à 6 et est maintenue par le cadre de support (37), le cadre de support (37) étant relié au boîtier (46) par enfichage à l'aide d'une jambe de soutien (38, 39, 40, 41) formée sur le cadre de support (37) de telle sorte que la carte de circuit (2) soit maintenue en position prédéterminée dans une cavité entourée par le boîtier (46).
